## Europäisches Patentamt

## European Patent Office

## Office européen des brevets

(11) Veröffentlichungsnummer: **0 081 804**
**B1**

(19)
(12)

# EUROPÄISCHE PATENTSCHRIFT

(45) Veröffentlichungstag der Patentschrift:
15.10.86

(21) Anmeldenummer: **82111357.8**

(22) Anmeldetag: **08.12.82**

(51) Int. Cl.⁴: **H 01 L 21/265,** H 01 L 21/31, H 01 L 21/82, H 01 L 27/08

(54) **Verfahren zur Herstellung benachbarter mit Dotierstoffionen implantierter Wannen bei der Herstellung von hochintegrierten komplementären MOS-Feldeffekttransistorschaltungen.**

(30) Priorität: **11.12.81 DE 3149185**

(43) Veröffentlichungstag der Anmeldung:
**22.06.83 Patentblatt 83/25**

(45) Bekanntmachung des Hinweises auf die Patenterteilung:
**15.10.86 Patentblatt 86/42**

(84) Benannte Vertragsstaaten:
**DE FR GB IT SE**

(56) Entgegenhaltungen:
**GB-A-2 075 257**
**US-A-4 209 797**
**US-A-4 280 272**

**IEDM TECHNICAL DIGEST 1980, International Electron Devices Meeting, Washington D.C., 8.-10. Dezember 1980, New York (US) L.C. PARRILLO et al.: "Twin-tub CMOS - A technology for VLSI circuits", Seiten 752-755**
**JAPANESE JOURNAL OF APPLIED PHYSICS, Band 18, Proceedings of the 10th Conference on Solid State Devices, 1979, Tokyo (JP) Y. SAKAI et al.: "High Packing Density, High Speed CMOS (Hi-CMOS) Device Technology", Seiten 73-78**

(73) Patentinhaber: **Siemens Aktiengesellschaft Berlin und München, Wittelsbacherplatz 2, D-8000 München 2 (DE)**

(72) Erfinder: **Schwabe, Ulrich, Dr., Grünwalderstrasse 40, D-8000 München 90 (DE)**
Erfinder: **Jacobs, Erwin, Dr., Stieglitzweg 9b, D-8011 Vaterstetten (DE)**

## Beschreibung

Die vorliegende Patentanmeldung betrifft ein Verfahren zur Herstellung benachbarter mit Dotierstoffionen implantierter Wannen bei der Herstellung von hochintegrierten komplementären MOS-Feldeffekttransistorschaltungen (CMOS-Schaltungen), bei dem für die Aufnahme der n- bzw. p-Kanaltransistoren der Schaltung im Siliziumsubstrat in einer auf das Substrat aufgebrachten epitaktischen Schicht p- bzw. n-dotierte Wannen erzeugt werden, in welche zur Einstellung der verschiedenen Transistoreinsatzspannungen die entsprechenden Dotierstoffatome durch mehrfache Ionenimplantation eingebracht werden und wobei die Maskierung für die einzelnen Ionenimplantationen durch Fotolack- und/oder durch Siliziumoxid bzw. Siliziumnitrid-Strukturen erfolgt.

Die Aufgabe, die der vorliegenden Erfindung zugrundeliegt, besteht in der Durchführung eines CMOS-Prozesses, bei dem möglichst wenige Prozeßschritte zur Herstellung der gewünschten Schaltungen erforderlich sind, bei dem aber trotzdem gewährleistet wird, daß die Funktionsweise der Bauelemente der Schaltung dadurch nicht beeinträchtigt wird. Insbesondere soll eine starke räumliche Überlappung und ladungsmäßige Kompensation an der Implantationskante der beiden n- bzw. p-implantierten Wannengebiete vermieden werden.

Bei den aus dem Stand der Technik bekannten Prozessen zur Herstellung von hochintegrierten komplementären MOS-Feldeffekttransistoreschaltungen (CMOS-Schaltungen) werden zur Einstellung der verschiedenen Transistoreinsatzspannungen Mehrfachimplantationen nach verschiedenen Technologien verwendet, die sehr aufwendig sind.

So ist aus einem Aufsatz von L. C. Parillo et al. "Twin Tub CMOS - A Technology for VLSI Circuits" aus dem Techn. Dig. IEDM 1980, 29.1., Seiten 752-755 bekannt, die beiden n- bzw. p-dotierten Wannen in einem CMOS-Prozeß mittels selbstjustierender Prozeßschritte unter Verwendung nur einer Maske herzustellen. Die selbstjustierende Implantation der beiden Wannen führt bei der üblichen Eindringtiefe $x_j \approx$ 5 μm (p- und n-Wanne) an der Implantationskante zu einer starken räumlichen Überlappung und ladungsmäßigen Kompensation der n- bzw. p-implantierten Gebiete. Eine negative Folge davon ist, daß die Einsatzspannung des Feldoxidtransistors reduziert wird und die Stromverstärkung der parasitären npn- und pnp-Bipolartransistoren erhöht wird, was zu einer vergrößerten "latch-up"-Anfälligkeit (das ist Zündwahrscheinlichkeit des parasitären Thyristors) führt. Eine starke Reduzierung der Dickoxideinsatzspannung wie "latch-up" führen zu einem Ausfall des Bauelements.

Ein anderes Verfahren, welches sowohl die beiden Wannen als auch die Kanal- und Feldimplantation unter Verwendung getrennter Masken durchführt, ist aus einem Aufsatz von Y. Sakai et al. "High Packing Density, High Speed CMOS (Hi-CMOS) Device Technology", aus dem Jap. J. Appl. Phys. 18, Suppl. 18-1, Seite 73-78, zu entnehmen. Der Nachteil dieses Verfahrens ist, daß, bedingt durch die Anzahl der benötigten Maskenschritte der an und für sich schon in Bezug auf die Ausbeute kritische CMOS-Fertigungsprozeß sehr belastet wird.

Alle diese Nachteile werden durch das Verfahren nach der Lehre der Erfindung dadurch vermieden, daß

a) die Herstellung der p-Wanne durch eine Bor-Ionenimplantation in der n-dotierten, auf dem n+-dotierten Substrat aufgebrachten, mit einer Oxidschicht bedeckten epitaktischen Schicht nach erfolgter Maskierung der übrigen Bereiche mit einer Siliziumnitridmaske erfolgt,

b) die Oxidschicht abgelöst wird, wobei gezielt eine Unterätzung der Siliziumnitridschicht durchgeführt wird,

c) ein lokaler Oxidationsprozeß durchgeführt wird und die Borionen bis zu einer Eindringtiefe $x_{jp}$, die im Bereich der Dicke der epitaktischen Schicht liegt, eindiffundiert werden,

d) die Siliziumnitridmaskierung abgelöst wird und

e) die n-Wanne durch eine Phosphor- oder Arsen-Ionenimplantation und anschließende Diffusion mit einer wesentlich geringeren Eindringtiefe $x_{jn}$ als die der p-Wanne ($x_{jp}$), wobei $x_{jp} \geq x_{jn}$ ist, hergestellt wird.

Im Gegensatz zu dem bekannten Verfahren nach Parillo wird die p-Wanne vor der n-Wanne implantiert und anschließend bis zur Tiefe $x_{jp}$ eindiffundiert. Es ist ein wesentlicher Bestandteil der Erfindung, daß die Dicke der epitaktischen Schicht gleich oder nur geringfügig größer als die Eindringtiefe $x_{jp}$ gewählt wird. Ein weiterer wesentlicher Unterschied zum bekannten Verfahren nach Parillo besteht in der um einen Faktor $\geq 4$ geringeren Eindringsiefe $x_{jn}$ der n-Wanne - gemäß einem besonders günstigen Ausführungsbeispiel 1 bis 1,5 μm bei 6 μm Eindringtiefe von $x_{jp}$ -, welche getrennt von der p-Wanne implantiert und eingetrieben wird. Dadurch werden die Nachteile der gegenseitigen weitreichenden Kompensation von p- und n-Wanne vermieden, die bei einem gleichzeitigen Eindiffundieren und praktisch gleicher Eindringtiefe $x_{jp} \approx x_{jn}$ (nach Parillo) auftreten.

Eine weitere erfindungsgemäße Maßnahme zur räumlichen Separation der beiden Wannen ist die starke Unterätzung der Nitridmaske beim Ablösen der Oxidschicht. Dabei wird die Kante der nachfolgenden Maskieroxidation um 1 bis 2 μm nach außen verschoben und die Implantation der n-Wanne ist um diesen Abstand von der Implantationskante der p-Wanne getrennt.

Eine weitere Möglichkeit, eine Trennung der Wannenimplantationen zu erreichen, ergibt sich in einer Weiterbildung des Erfindungsgedankens dadurch, daß antelle oder neben der gezielten Unterätzung der Siliziumnitridschicht beim Ablösen der Oxidschicht im lokalen Oxidationsprozeß ein möglichst langer Vogelschnabel (birdsbeak) gebildet wird, welcher ebenfalls die Phosphor-Ionenimplantation maskiert. Die Bildung eines solchen Vogelschnabels ist durch einen Hochdruckoxidationsprozeß (1 bis 2. $10^6$ Pa) bei niederer Temperatur (700° C) erreichbar.

Die n-Wanne ist selbstjustierend zur p-Wanne und kann sowohl mittels einer Phosphor- als auch Arsen-Ionenimplantation hergestellt werden. Infolge der hohen Implantationsdosis von $9 \times 10^{11}$ $cm_{-2}$ ist eine Feldionenimplantation nicht mehr nötig, und es kann die Feldionenimplantationsmaske eingespart werden. Zur Definition von p-Wanne, n-Wanne und Feldbereich (p-Kanal) ist nur eine Maske erforderlich.

Weitere Ausgestaltungen der Erfindung ergeben sich aus den Unteransprüchen.

Im folgenden soll anhand eines Ausführungsbeispiels und der Figuren 1 bis 9 die Erfindung an der Herstellung eines Zwei-Wannen-Prozesses mit einem n-Kanal und p-Kanal-Transistor noch näher erläutert werden. Dabei zeigen

die Figuren 1 bis 7 im Schnittbild die durch die einzelnen Verfahrensschritte erzielten Strukturen, wobei in jeder Figur der Einfachheit halber mehrere Prozesse dargestellt sind, und

die Figuren 8 und 9 im Detail die durch die Unterätzung der Nitridmaske und nachfolgende Maskieroxidation weitgehend erreichte räumliche Trennung der beiden Wannen.

In allen Figuren gelten für gleiche Teile gleiche Bezugszeichen.

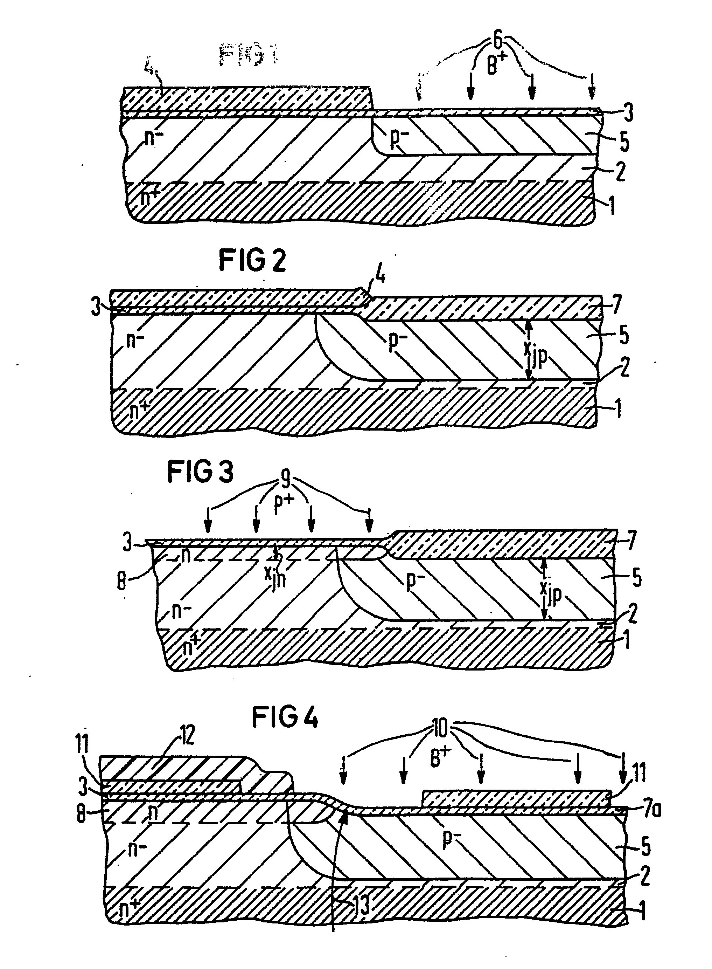

Figur 1: Zu Beginn der Prozeßfolge wird die p-Wanne (5) hergestellt. Dabei wird von einem, mit einer n-dotierten Epitaxieschicht 2 ($<100>$ -Si, 10 bis 50 Ohm cm) versehenen, $n^+$-dotierten Substrat 1 ($<100>$-Si, 0.01 bis 0.1 Ohm cm) ausgegangen, welches mit einer Oxidschicht 3 (50 nm) und mit einer, mit Hilfe einer Fotolacktechnik (nicht abgebildet) strukturierten Siliziumnitridschicht 4 von 100 nm Dicke versehen ist. Die Bor-Ionenimplantation 6 zur Erzeugung der p-Wanne erfolgt mit einer Dosis und Energie von $1,5 \times 10^{12}$ $cm^{-2}$ bzw. 160 keV.

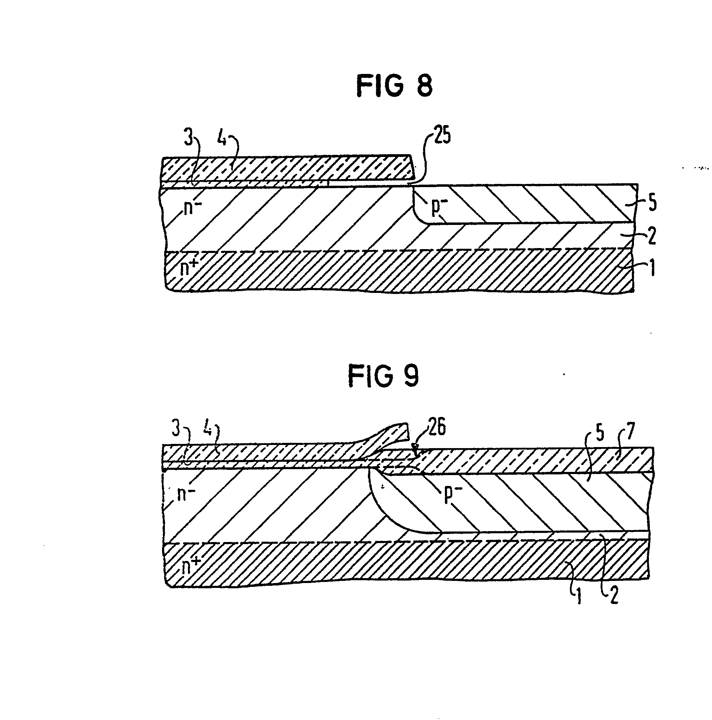

Figur 2: Nach dem Ablösen der Oxidschicht 3, wobei gezielt eine Unterätzung der Siliziumnitridschicht 4 durchgeführt wird, (siehe Figur 8) erfolgt ein Oxidationsprozeß. Die neu erzeugte Oxidschicht ist mit 7 bezeichnet und weist eine Dicke von 400 nm auf. In einem nachfolgenden Diffusionsprozeß werden die Bor-Ionen bis zu einer Eindringtiefe $x_{jp}$ von 6 /um in die Epitaxieschicht 2 eindiffundiert. Die Dicke der Epitaxieschicht 2 beträgt 7 µm.

Figur 3: Die Siliziumnitridschicht 4 wird entfernt. Die Herstellung der n-Wanne 5 erfolgt durch eine ganzflächige Phosphor- oder Arsen-Ionenimplantation 9 mit einer Implantationsdosis und Energie von $9 \times 10^{11}$ $cm^{-2}$ bzw. 150 keV und anschließender Eindiffusion bis zu einer

Eindringtiefe $x_{jn}$ von 1 bis 1,5 µm. Infolge der hohen Implantationsdosis kann die Feldionenimplantation für die Einstellung der Einsatzspannung der p-Kanaldickoxidtransistoren eingespart werden und damit eine zusätzliche Maske.

Figur 4: Nach dem Eintreiben der Phosphor- bzw. Arsen-Ionen für die n-Wanne 5 wird die Oxidschicht abgeätzt, und es folgen die Oxidation der Schicht 7a (50 nm) und die Siliziumnitridabscheidung 11 in einer Schichtdicke von 120 nm und die Strukturierung der Siliziumnitridschicht (Maske LOCOS). Die Feldimplantation der p-Wanne 5 mit Bor-Ionen erfolgt nach Maskierung der n-Wanne 8 und des gesamten Transistorbereichs der n-Kanaltransistoren in der p-Wanne 5 mit der Siliziumnitridschicht 11. Alle Bereiche außer den p-Wannenbereichen werden während der Bor-Ionenimplantation 10 mit einer Fotolackstruktur 12 abgedeckt. Die Implantationsdosis und Energie der Bor-Ionenimplantation 10 wird auf $1 \times 10^{13}$ $cm^{-2}$ und 25 keV eingestellt. Die mit dem Pfeil 13 in Figur 4 angezeigte Oberflächenkante wird in den folgenden Figuren vernachlässigt.

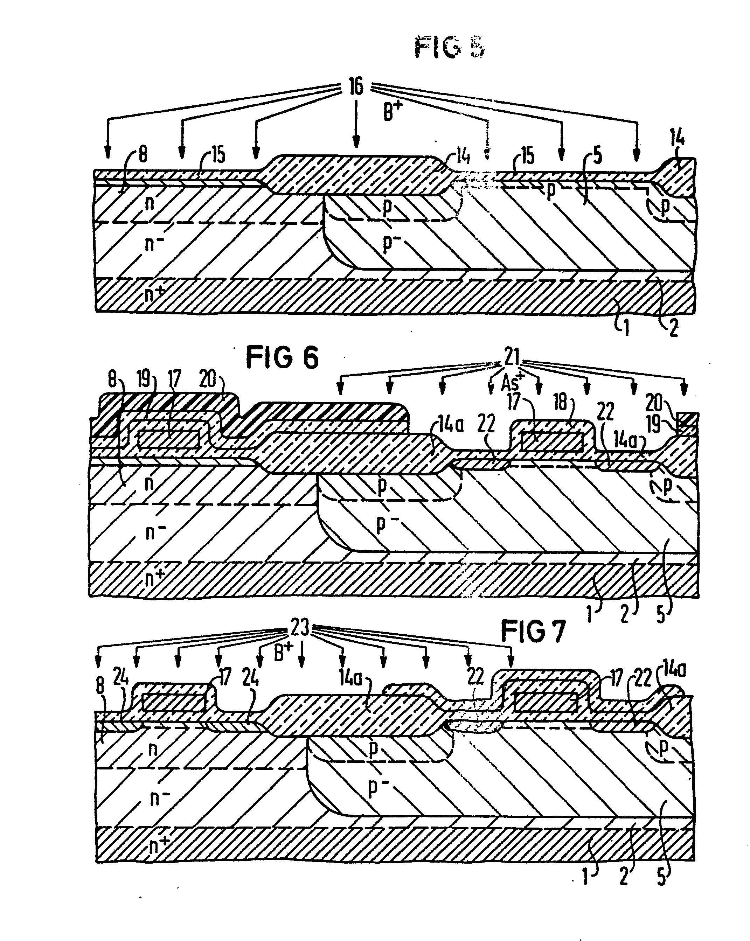

Figur 5: Nach Entfernung der Fotolackstruktur 12 werden dann unter Verwendung der Siliziumnitridschicht 11 als Maskierung die Feldoxidbereiche 14 in einer Schichtdicke von 1000 nm durch lokale Oxidation erzeugt. Nach Ablösung der Siliziumnitridschicht 11 erfolgt eine thermische Oxidation der gesamten Oberfläche, wobei die Dicke der Gateoxidschicht 15 mit 40 mm (kleiner als bei üblichen CMOS-Prozessen) eingestellt wird. Dann erfolgt eine ganzflächige Bor-Ionenimplantation 16 zur Dotierung des p- und n-Kanals, wobei die Implantationsdosis in Abstimmung mit den anderen Implantationen so gewählt wird, daß für den n- und den p-Kanal-Transistor eine möglichst symmetrische Einsatzspannung $U_T$ erreicht wird. Im Ausführungsbeispiel wird die Implantationsdosis und Energie auf $6 \times 10^{11}$ Bor $cm^{-2}$ bzw. 25 keV eingestellt, was einer Einsatzspannung ($U_T$) = 0.8 V entspricht. Da die Ionenimplantation ganzflächig erfolgt, wird im Gegensatz zu bekannten CMOS-Prozessen keine Maske benötigt.

Figur 6: Es erfolgt nun die Abscheidung der Polysiliziumebene (500 nm) und ihre Strukturierung, wobei die Gatebereiche 17 erzeugt werden. Dann wird die gesamte Oberfläche thermisch aufoxidiert, wobei zum einen die freiliegende Oxidschicht zu einem Streuoxid 14a aufoxidiert wird, zum anderen wächst ein ca. 100 nm dickes Oxid 18 auf den Polysiliziumbereichen 17 auf. Diese thermische Aufoxidation wird so geführt, daß die Oxidschichtdicke über den Source/Drain-Bereichen der n-Kanal-Transistoren in der p-Wanne 5 die spätere Source/Drain-Implantation nicht maskiert. Diese Oxidschicht (14a, 15) bildet die Unterlage für die nun aufzubringende Siliziumnitridschicht 19, deren Dicke so gewählt wird, daß sie die Maskierung gegen die

nachfolgende Arsen-Ionenimplantation 21 zur Erzeugung der n-Kanal-Transistoren in der p-Wanne 7 gewährleistet. Mittels einer Fotolackstruktur 20 wird die Siliziumnitridschicht 19 so strukturiert, daß die Bereiche der p-Kanaltransistoren in der n-Wanne 8 davon bedeckt bleiben. Dann wird die Arsen-Ionenimplantation 21 mit einer Dosis von 6 x 10$^{15}$ cm$^{-2}$ und einer Energie von 80 keV durchgeführt und die Source/Drain-Bereiche 22 der n-Kanal-Transistoren erzeugt. Im Gegensatz zu dem aus dem Aufsatz von Motamedi et al "Design and Evaluation of Ion Implanted CMOS Struktures" aus dem IEEE Transact. Electr. Devices Vol. ED-27, Nr. 3, Seiten 578-583 bekannten Verfahren, bei dem für die n+- und die p+-Implantationen eigene Massen verwendet werden, was eine Verringerung der Ausbeute zur Folge hat, wird beim Verfahren nach einer Weiterbildung der Lehre der Erfindung für beide Source/Drain-Implantationen nur eine Maske verwendet, jedoch keine Doppelimplantation in ein Source/Drain-Diffusionsgebiet (wie bei Parillo et al oder dem aus dem Aufsatz De Witt Ong "An All-Implanted CCD/CMOS Process" aus dem IEEE Transact. Electr. Dev. ED-28 (1981), auf den Seiten 6 bis 12 bekannten Verfahren) durchgeführt.

Figur 7: Bei der nach der Arsen-Ionenimplantation 21 erfolgten thermischen Oxidation, bei der auch die Source/Drainbereiche 22 der n-Kanal-Transistoren eingetrieben werden, werden die Oxide im n+-Bereich (22) auf Dicken aufoxidiert, die eine ausreichende Maskierung bei der noch folgenden Bor-Implantation 23 zur Erzeugung der p-Kanaltransistoren gewährleistet. Im Ausführungsbeispiel beträgt diese Dicke 250 nm. Diese Oxidation ist praktisch wegen der noch vorhandenen Nitridschicht 19 ein zweiter LOCOS-Schritt. Nach Entfernung der Nitridstruktur 19 wird nun die ganzflächige Bor-Ionenimplantation 23 zur Erzeugung der Source/Drain-Bereiche der p-Kanaltransistoren in der n-Wanne 8 durchgeführt. Dabei werden Dosis und Energie auf 4 x 10$^{15}$ cm$^{-2}$ bzw. 25 keV eingestellt. Nach dem Eintreiben der implantierten Boratome entstehen die Source/Drain-Bereiche 24 der p-Kanal-Transistoren.

Die Erzeugung der Isolationsschicht, der Kontaktlochbereiche und der Metall-Leiterbahnebene erfolgt nach bekannten Verfahrensschritten der CMOS-Technologie.

Figur 8 und 9: Die starke Unterätzung 25 der Siliziumnitridmaske 4 beim Ablösen der Oxidschicht 3 nach erfolgter Bor-Ionenimplantation 5 zur Erzeugung der p-Wanne 5 erlaubt bei der nachfolgenden Maskieroxidation ein Verschieben der Kante nach außen. Die Implantation der n-Wanne (8) ist um diesen Abstand (1 bis 2 μm) von der Implantationskante der p-Wanne 5 getrennt (siehe Pfeil 26).

**Patentansprüche**

1. Verfahren zur Herstellung benachbarter mit Dotierstoffionen implantierter Wannen bei der Herstellung von hochintegrierten komplementären MOS-Feldeffekttransistorschaltungen (CMOS-Schaltungen), bei dem für die Aufnahme der n- bzw. p-Kanaltransistoren der Schaltung im Siliziumsubstrat (1) in einer auf das Substrat (1) aufgebrachten epitaktischen Schicht (2) p- bzw. n-dotierte Wannen (5, 8) erzeugt werden, in welche zur Einstellung der verschiedenen Transistoreinsatzspannungen die entsprechenden Dotierstoffatome durch mehrfache Ionenimplantation (6, 9, 10, 16, 21, 23) eingebracht werden und wobei die Maskierung für die einzelnen Ionenimplantationen durch Fotolack- und/oder durch Siliziumoxid bzw. Siliziumnitrid-Strukturen erfolgt, gekennzeichnet durch den Ablauf folgender Verfahrensschritte:
   a) Herstellung der p-Wanne (5) durch eine Bor-Ionenimplantation (5) in der n-dotierten, auf dem n+-dotierten Substrat (1) aufgebrachten, mit einer Oxidschicht (3) bedeckten Epitaxieschicht (2) nach erfolgter Maskierung der übrigen Bereiche mit einer Siliziumnitridmaske (4),
   b) Ablösen der Oxidschicht (3), wobei gezielt eine Unterätzung (25) der Siliziumnitridschicht (4) durchgeführt wird,
   c) Durchführung eines lokalen Oxidationsprozesses und Eindiffusion der Bor-Ionen bis zu einer Eindringtiefe $x_{jp}$, die im Bereich der Dicke der Epitaxieschicht (2) ist,
   d) Ablösen der Siliziumnitridmaskierung (4) und
   e) Herstellung der n-Wanne (8) durch eine Phosphor- oder Arsen-Ionenimplantation (9) und anschließender Diffusion in einer wesentlich geringeren Eindringtiefe $x_{jn}$ als der p-Wanne ($x_{jp}$), wobei $x_{jp} \geqslant 4x_{jn}$ ist.

2. Verfahren nach Anspruch 1, dadurch gekennzeichnet, daß in Abänderung des Verfahrens nach Anspruch 1 anstelle oder zusätzlich zu der gezielten Unterätzung der Siliziumnitridschicht (4) beim Ablösen der Oxidschicht (3) nach Verfahrensschritt b) der Oxidationsprozeß nach Verfahrensschritt c) bei einem Druck von 1 bis 2.10$^6$ Pa und einer Temperatur in Bereich von 700°C durchgeführt wird.

3. Verfahren nach Anspruch 1 und 2, dadurch gekennzeichnet, daß als Substratmaterial (1) mit Antimon n+-dotiertes, (100)-orientiertes Silizium mit einem spezifischen Widerstand von 0,01 bis 0,1 Ohm. cm verwendet wird.

4. Verfahren nach Anspruch 1 bis 3, dadurch gekennzeichnet, daß der spezifische Widerstand der n-dotierten, (100)-orientierten epitaktischen Schicht (2) auf 10 bis 50 Ohm cm eingestellt wird.

5. Verfahren nach Anspruch 1 bis 4, dadurch gekennzeichnet, daß zur Herstellung der n-Wanne (5) durch eine Phosphor- oder Arsen-Ionenimplantation (9) die Implantationsdosis auf 8 bis 12 x 10$^{11}$ cm$^{-2}$ bei 160 keV eingestellt wird.

6. Verfahren nach Anspruch 1 bis 5, dadurch gekennzeichnet, daß die Tiefe der p-Wanne (5) ($x_{jp}$) auf ≤ 6 µm eingestellt wird.

7. Verfahren nach Anspruch 1 bis 6, dadurch gekennzeichnet, daß die Tiefe der n-Wanne (5) ($x_{jn}$) auf ≤ 1,5 µm eingestellt wird.

8. Verfahren nach Anspruch 1 bis 7, dadurch gekennzeichnet, daß zur Herstellung von CMOS-Schaltungen die Erzeugung der Source/Drain- und Gatebereiche sowie die Erzeugung des Zwischen- und Isolationsoxids und der Leiterbahnebene nach Durchführung der Verfahrensschritte a) bis e) nach Patentanspruch 1 durch folgende Verfahrensschritte erfolgt:

f) Durchführung der Feldimplantation für die n-Kanaltransistoren im Bereich der p-Wanne (9) nach Maskierung der n-Wanne (5) mittels einer Siliziumnitrid- (11) und Fotolackschicht (12) und des gesamten Transistorbereiches der n-Kanaltransistoren in der p-Wanne (8) mit einer Siliziumnitridschicht (11),

g) Herstellung der Feldoxidbereiche (14) mittels lokaler Oxidation unter Verwendung der Siliziumnitridschicht (11) als Maskierung,

h) thermische Oxidation der gesamten Oberfläche nach Ablösen der Siliziumnitridmaskierung (11) zur Einstellung der Gateoxiddicke (15),

i) ganzflächige Bor-Ionenimplantation (16) zur Dotierung des p- und n-Kanals, wobei die Implantationsdosis in Abstimmung mit den anderen Implantationen so gewählt wird, daß für den n- und den p-Kanal-Transistor eine möglichst symmetrische Einsatzspannung $U_T$ erreicht wird,

j) Abscheidung und Strukturierung von Polysilizium zur Bildung der Gatebereiche (17),

k) thermische Aufoxidation der gesamten Oberfläche in dem Maße, daß die Oxidschichtdicke über den Source/Drainbereichen (22) der n-Kanaltransistoren die spätere Source/ Drain-Implantation (21) nicht maskiert,

l) Abscheidung einer ganzflächigen, die Source-Drain-Bereiche (24) der p-Kanal-Tranistoren maskierenden Siliziumnitridschicht (19) in einer, der Implantationsenergie der nachfolgenden Source-Drain-Implantation angepaßten Schichtdicke,

m) Strukturierung der Siliziumnitridschicht (19) in der Weise, daß die Bereiche der p-Kanal-Transistoren von der Siliziumnitridschicht (19) bedeckt bleiben,

n) Durchführung der Arsen-Ionenimplantation (21) zur Erzeugung der Source-Drain-Bereiche (22) der n-Kanal-Transistoren,

o) thermische Aufoxidation der Oberfläche in dem Maße, daß die Oxidschichtdicke über den Source-Drain-Bereichen (22) der n-Kanal-Transistoren für die nachfolgende Implantation (23) zur Erzeugung der Source-Drain-Bereiche (24) der p-Kanal-Transistoren als Maskierungsschicht ausreicht,

p) Entfernen der Nitridschichtstrukturen (19),

q) Durchführung einer ganzflächigen Bor-Ionenimplantation (23) zur Erzeugung der Source-Drain-Bereiche (24) der p-Kanal-Transistoren, und

r) Erzeugung der Isolationsschicht, der Kontaktlochbereiche und der Metall-Leiterbahnstrukturebene in bekannter Weise.

9. Verfahren nach Anspruch 1 bis 8, dadurch gekennzeichnet, daß die Dicke der Gateoxidschicht (15) nach Verfahrensschritt h) auf maximal 40 nm eingestellt wird.

10. Verfahren nach Anspruch 1 bis 9, dadurch gekennzeichnet, daß die Oxidschichtdicke nach Verfahrensschritt k) über die Oxidationszeit auf einen Wert im Bereich von 50 bis 200 nm eingestellt wird.

11. Verfahren nach Anspruch 1 bis 10, dadurch gekennzeichnet, daß die Dicke der Siliziumnitridschicht (19) nach Verfahrensschritt 1) auf einen Wert im Bereich von 50 bis 150 nm eingestellt wird.

12. Verfahren nach Anspruch 1 bis 11, dadurch gekennzeichnet, daß die Dosis und Energie bei der Source-Drain-Ionenimplantation (21) der n-Kanal-Transistoren mit Arsen nach Verfahrensschritt n) auf 3 bis $10^{15}$ cm$^{-2}$ und 50 keV eingestellt wird.

13. Verfahren nach Anspruch 1 bis 12, dadurch gekennzeichnet, daß die Oxidschichtdicke nach Verfahrensschritt o) über die Oxidationszeit auf einen Wert im Bereich von 100 bis 300 nm eingestellt wird.

14. Verfahren nach Anspruch 1 bis 13, dadurch gekennzeichnet, daß die Dosis und Energie bei der Source-Drain-Ionenimplantation (23) der p-Kanaltransistoren mit Bor nach Verfahrensschritt q) auf 2 bis 5 x $10^{15}$ cm$^{-2}$ bzw. 25 keV eingestellt wird.

**Claims**

1. A process for producing adjacent wells, implanted with dopant ions, in the manufacture of highly-integrated, complementary MOS field effect transistor circuits (CMOS-circuits), where, for the accommodation of the n- and p-channel transistors of the circuit in the silicon substrate (1), p- and n-doped wells (5, 8) are produced in an epitaxial layer (2) applied to the substrate (1), into which wells the corresponding dopant atoms are introduced by multiple ion implantation (6, 9, 10, 16, 21, 23) in order to set the various transistor start voltages, and where the masking for the individual ion implantation steps is effected by photolacquer structures and/or by silicon oxide or silicon nitride structures, characterised by the sequence of the rollowing process steps:

a) production of the p-well (5) by boron ion implantation (6) in the n-doped epitaxial layer (2) which is applied to the n± doped substrate (1) and is covered with an oxide layer (3), after masking of the other zones with a silicon nitride mask (4),

b) stripping off of the oxide layer (3), together with a deliberate under-etching (25) of the silicon nitride layer (4),

c) carrying out or a local oxidation process and diffusing-in the boron ions to a penetration depth $x_{jp}$ which is in the region of the thickness or the epitaxial layer (2),

d) stripping off of the silicon nitride mask (4), and

e) production or the n-well (8) by phosphorus or arsenic ion implantation (9) and subsequent diffusion-in to a substantially smaller penetration depth $x_{jn}$ than the p-well ($x_{jp}$), where $x_{jp} \geq 4x_{jn}$.

2. A process as claimed in Claim 1, characterised in that, as a modification or the process claimed in Claim 1, in place or, or in addition, to the deliberate under-etching or the silicon nitride layer (4) during the stripping off or the oxide layer (3) in accordance with process step b), the oxidation process corresponding to process step c) is carried out at a pressure or 1 to $2.10^6$ Pa and at a temperature in the region or 700° C.

3. A process as claimed in Claim 1 and 2, characterised in that (100)-orientated silicon which is $n^+$-doped with antimony and which has a specific resistance or 0.01 to 0.1 Ohm cm is used as substrate material (1).

4. A process as claimed in Claim 1 to 3, characterised in that the specific resistance of the n-doped, (100)-orientated epitaxial layer (2) is set at 10 to 50 Ohm cm.

5. A process as claimed in Claim 1 to 4, characterised in that for the production or the n-well (8) by phosphorus or arsenic ion implantation (9), the implantation dose is set at 8 to $12 \times 10^{11}$ cm$^{-2}$ at 160 KeV.

6. A process as claimed in Claim 1 to 5, characterised in that the depth or the p-well (5) ($x_{jp}$) is set at $\leq 6\mu m$.

7. A process as claimed in Claim 1 to 6, characterised in that the depth or the n-well (8) ($x_{jn}$) is set at $\leq 1.5\mu m$.

8. A process as claimed in Claim 1 to 7, characterised in that for the manufacture or CMOS-circuits, the production of the source drain- and gate zones, as well as the production of the intermediate oxide and insulating oxide and the conductor path plane is effected after the carrying out or process steps a) to e) as claimed in Claim 1, by the following process steps:

f) effecting the field implantation for the n-channel transistors in the region of the p-well (9) after the masking or the n-well (8) by a silicon nitride layer (11) and a photolacquer layer (12) and or the entire transistor zone or the n-channel transistors in the p-well (6) with a silicon nitride layer (11),

g) production of the field oxide zones (14) by local oxidation, using the silicon nitride layer (11) as mask,

h) thermal oxidation or the entire surface after the stripping off of the silicon nitride mask (11) in order to set the gate oxide thickness (15),

i) full-surface boron ion implantation (16) for doping the p- and n-channels, the implantation dose being selected, in conformity with the other implantation steps, such that as symmetrical as possible a start voltage $U_T$ is achieved for the n- and pchannel transistors,

j) deposition and structuring of polysilicon to form the gate zones (17),

k) thermal oxidation or the entire surface to an extent such that the oxide layer thickness above the source/drain zones (22) of the n-channel transistors does not mask the subsequent sourcedrain implantation (21),

l) deposition of a full-surface silicon nitride layer (19), which masks the source-drain zones (24) of the p-channel transistors, in a layer thickness adapted to the implantation energy of the subseqent source-drain implantation,

m) structuring of the silicon nitride layer (19) in such manner that the zones of the p-channel transistors remain covered by the silicon nitride layer (19),

n) effecting arsenic ion implantation (21) to produce the sourcedrain zones (22) of the n-channel transistors,

o) thermal oxidation of the surface to an extent such that the oxide layer thickness above the source-drain zones (22) of the nchannel transistors is sufficient for it to act as a masking layer for the subsequent implantation step (23) for the production of the source-drain zones (24) of the p-channel transistors,

p) removal of the nitride layer structures (19), q) effecting a full-surface boron ion implantation (23) to produce the source-drain zones (24) of the p-channel transistors, and

r) production of the insulating layer, the contact hole regions and the metal conductor path structure plane in known manner.

9. A process as claimed in Claim 1 to 8, characterised in that the thickness of the gate oxide layer (15) in accordance with process step h) is set at a maximum of 40 nm.

10. A process as claimed in Claim 1 to 9, characterised in that the oxide layer thickness in accordance with process step k) is set by the oxidation time at a value in the range of from 50 to 200 nm.

11. A process as claimed in Claim 1 to 10, characterised in that the thickness of the silicon nitride layer (19) in accordance with process step 1) is set at a value in the range of from 50 to 150 nm.

12. A process as claimed in Claim 1 to 11, characterised in that the dosage and energy of the source-drain ion implantation (21) of the n-channel transistors with arsenic, in accordance with process step n), is set at 3 to $10^{15}$ cm$^{-2}$ and 80 keV.

13. A process as claimed in Claim 1 to 12, characterised in that the oxide layer thickness in accordance with process step o) is set by the oxidation time at a value in the range of from 100 to 300 nm.

14. A process as claimed in Claim 1 to 13, characterised in that the dosage and energy of the source-drain ion implantation (23) of the p-channel transistors with boron, in accordance with process step q), is set at 2 to $5 \times 10^{15}$ cm$^{-2}$

and 25 keV.

**Revendications**

1. Procédé de formation de puits adjacents à implantation d'ions de la substance de dopage dans la fabrication, à forte intensité d'intégration, de circuits à transistors à effet de champ MOS complémentaires (circuits CMOS), dans lequel on produit, pour recevoir les transistors à canal n ou p du circuit dans le substrat en silicium (1), des puits (5, 8) à dopage en n ou en p dans une couche épitaxiale (2) déposée sur le substrat (3), et dans lequel, en vue d'ajuster les différentes tensions de service des transistors, les atomes correspondants de la substance de dopage sont introduits par des implantations multiples (6, 9, 10, 16, 21, 23) des ions, le masquage pour les différentes implantations des ions étant opéré par des structures en vernis photosensible, et/ou en oxyde de silicium ou en nitrure de silicium, caractérisé par le fait

a) que la réalisation des puits (5) du type p a lieu par une implantation s'ions se bore dans la couche épitaxiale (2) dopée en n déposée sur le substrat (1) dopé en n+ et recouverte d'une couche d'oxyde (3), après masquage des autres zones à l'aide d'un masque en nitrure de silicium (4)

b) que la couche d'oxyde (3) est enlevée, une sous-gravure de la couche de nitrure de silicium (4), étant réalisée intentionnellement,

c) qu'un processus localise d'oxydation est réalisé, alors que les ions de bore sont diffusés jusqu'a une profondeur de pénétration $x_{jp}$ qui se situe dans la zone de l'épaisseur de la couche épitaxiale (2),

d) que l'on enlève le masquage en nitrure de silicium (4), et

e) que le puits (8) de type n est réalisé par implantation (9) d'ions de phosphore ou d'arsenic et que la diffusion qui y fait suite est opérée avec une profondeur de pénétration $x_{jn}$ qui est notablement plus faible que celle du puits de type p ($x_{jp}$) avec $x_{jp} \geqq 4 \, x_{jn}$

2. Procédé selon la revendication 1, caractérisé par le fait qu'en variante du procédé selon la revendication 1, et à la place où en plus de la sousgravure intentionnelle de la couche de nitrure de silicium (4), on réalise, lors de la suppression de la couche d'oxyde (3) selon la phase opératoire b) du processus d'oxydation, après la phase opératoire c), le processus d'oxydation selon la phase opératoire c) est réalisé sous une pression de 1 à $2.10^6$ Pa et a une température qui se situe dans la plage de 700°C.

3. Procédé selon la revendication 1 et 2, caractérisé par le fait que l'on utilise, comme substance du substrat (1) du silicium à orientation (100) et dopé avec de l'antimoine n+, avec une résistance spécifique de 0,01 à 0,1 Ohm. cm.

4. Procédé selon les revendications 1 à 3, caractérisé par le fait que la résistance spécifique de la couche épitaxiale à orientation (100) et dopée en n, est ajustée à 10 à 50 Ohm cm.

5. Procédé selon la revendication 1 à 4, caractérisé par le fait que pour la fabrication des puits (8) du type n à l'aide d'une implantation (9) d'ions de phosphore ou d'arsenic, la dose d'implantation est ajustée à 8 à $12 \times 10^{11}$ cm$^{-2}$ pour 160 keV.

6. Procédé selon la revendication 1 à 5, caractérisé par le fait que la profondeur ($x_{jp}$) des puits (5) du type n est réglée pour être plus petite à 6 µm.

7. Procédé selon la revendication 1 à 6, caractérisé par le fait que la profondeur ($x_{jn}$) du puits (8) du type n, est ajustée de manière à être plus petite ou égale à 1,5 µm.

8. Procédé selon la revendication 1 à 7, caractérisé par le fait que pour la préparation de circuits CMOS la réalisation des zones de source/de drain et de zones de grille, ainsi que pour réaliser l'oxyde intermédiaire et l'oxyde d'isolation ainsi que le plan des pistes conductrices, on opère, après réalisation des phases opératoires a) à e) selon la revendication 1, à l'aide des phases opératoires suivantes:

f) réalisation de l'implantation de champ pour les transistors à canal n dans la zone du puits p (9) après masquage du puits n (8) à l'aide d'une couche de nitrure de silicium (11) et d'une couche d'un vernis photosensible (12) ainsi que de la totalité de la zone du transistor des transistors à canal du type n dans le puits p (6), avec une couche de nitrure de silicium (11),

g) réalisation des zones d'oxyde de champ (14) à l'aide d'une oxydation localisée, avec mise en oeuvre de la couche de nitrure de silicium (11) en tant que masquage,

h) oxydation thermique de la totalité de la surface, après suppression du masquage au nitrure de silicium (11) en vue d'ajuster l'épaisseur de l'oxyde de grille (15),

i) implantation d'ions de bore (18) sur toute la surface, pour le dopage du canal p et du canal n, la dose d'implantation étant choisie, en fonction avec les autres implantations de façon que l'on obtienne pour le transistor à canal n et pour le transistor à canal p, une tension de service $U_T$ aussi symétrique que possible,

j) dépôt et structuration du polysilicium en vue de la formation des zones de grille (17),

k) oxydation thermique de la totalité de la surface dans une mesure telle que l'épaisseur de la couche d'oxyde sur les zones de source/de drain (22) des transistors à canal n, ne pasque pas l'implantation de la source/du drain (21) à réaliser ultérieurement,

l) dépôt d'une couche de nitrure de silicium (19) sur toute la surface et masquant les zones de source de drain (24) des transistors à canal p, avec une épaisseur de couche qui est adaptée à l'énergie à'implantation de l'implantation ultérieure de la source et du drain,

m) structuration de la couche de nitrure de silicium (19) de façon que les zones des transistors à canal p restent recouvertes par la couche de nitrure de silicium (19),

n) réalisation de l'implantation (21) avec des ions d'arsenic en vue de produire les zones de source et de drain (22) des transistors à canal n,

o) oxydation thermique de la surface au point que l'épaisseur de la couche d'oxyde sur les zones de source-de drain (22) des transistors à canal n, soit suffisante, en tant que couche de masquage, pour l'implantation ultérieure (23) qui sert à produire les zones de source-de drain (24) des transistors à canal p,

p) suppression des structures à couche de nitrure (19),

q) réalisation sur toute la surface de l'implantation d'ions de bore (23) en vue de produire les zones de source- de drain (24) des transistors à canal p, et

r) production de la couche isolante, des zones à trous de contact et des plans métalliques pour la structure des pistes conductrices, de façon connue en soi.

9. Procédé selon la revendication 1 à 8, caractérisé par le fait que l'épaisseur de la couche d'oxyde de grille (15) est ajustée, selon la phase opératoire h) à un maximum de 40 nm.

10. Procédé selon la revendication 1 à 9, caractérisé par le fait que l'épaisseur de la couche d'oxyde suivant la phase opératoire k), est réglée dans le temps de l'oxydation, à une valeur qui se situe dans la plage de 50 à 200 nm,

11. Procédé selon la revendication 1 à 10, caractérisé par le fait que l'épaisseur de la couche de nitrure de silicium (19) est ajustée, après la phase opératoire 1), à une valeur qui se situe dans la plage de 50 à 150 nm.

12. Procédé selon la revendication 1 à 11, caractérisé par le fait que la dose et l'énergie pour l'implantation d'ions (21) de la source-du drain des transistors à canal n, avec de l'arsenic selon la phase opératoire n) sont réglées à 3 à $10^{15}$ cm$^{-2}$ et à 80 keV.

13. Procédé selon la revendication 1 à 12, caractérisé par le fait que l'épaisseur de la couche d'oxyde selon la phase opératoire o) est ajustée, dans le temps de l'oxydation, à une valeur qui se situe dans la plage de 100 à 300 nm.

14. Procédé selon la revendication 1 à 13, caractérisé par le fait que le dose et l'énergie pour l'implantation d'ions (23) de la source-du drain des transistors à canal p, avec du bore et selon la phase opératoire q), sont ajustées à 2 à 5 x $10^{15}$ cm$^{-2}$ respectivement 25 keV.

FIG 1

FIG 2

FIG 3

FIG 4

## FIG 5

16

B+

8   15   14   15   5   14

n

p

n⁻   p

p⁻

p

n⁺

1   2

## FIG 6

21

As⁺

8   19   17   20   17   18   22   20   19

14a   22   14a

n   p

n⁻   p

p⁻

n⁺

1   2   5

## FIG 7

23

B⁺

8   24   17   24   14a   22   17   22   14a

n   p

n⁻

p⁻   p

n⁺

1   2   5

## FIG 8

## FIG 9